# EUROPEAN PATENT SPECIFICATION

(11) **EP 4 567 889 B1**
(45) Date of publication and mention of the grant of the patent: **11.11.2026**
(21) Application number: 23214164.8
(22) Date of filing: 05.12.2023
(51) Int. Cl.: H10D 89/60, H10D 10/00, H10D 62/17

(54) **IMPROVED OPEN BASE TRANSISTOR**
VERBESSERTER TRANSISTOR MIT OFFENER BASIS
TRANSISTOR À BASE OUVERTE AMÉLIORÉ

(43) Date of publication of application: 11.06.2025
(73) Proprietor: Nexperia B.V., 6534 AB Nijmegen (NL)
(72) Inventor: Puttaswamy, Hema Eraganahalli, Hamburg (DE); Ritter, Hans-Martin, Hamburg (DE)
(74) Representative: Pjanovic, Ilija

(56) References cited:
- US-A1- 2004 085 691
- US-A1- 2004 104 437
- US-A1- 2018 286 853

## Description

### Technical field

The present disclosure relates to open base transistors, such as open base Bipolar Junction Transistor (BJT) transistors. The open base transistor of the present disclosure may be used in Electrostatic Discharge (ESD) applications.

### Background

A BJT is a type of transistor that may be used in electronic circuits to amplify or switch electrical signals. BJTs exist as PNP and NPN types, based on the doping types of the three main terminal regions. An NPN transistor includes two semiconductor junctions that share a P-doped region, and a PNP transistor includes two semiconductor junctions that share an N-doped region.

In normal transistor operation, a base current is used to control the collector current, allowing the transistor to amplify or switch signals. In typical operation, the base-emitter junction is forward biased, which means that the P-doped side of the junction is at a more positive potential than the N-doped side, and the base-collector junction is reverse biased. When forward bias is applied to the base-emitter junction, the equilibrium between the thermally generated carriers and the repelling electric field of the emitter depletion region is disturbed. This allows thermally excited carriers (electrons in NPNs, holes in PNPs) to inject from the emitter into the base region. These carriers create a diffusion current through the base from the region of high concentration near the emitter toward the region of low concentration near the collector. The collector-base junction is reverse-biased, and so negligible carrier injection occurs from the collector to the base, but carriers that are injected into the base from the emitter, and diffuse to reach the collector-base depletion region, are swept into the collector by the electric field in the depletion region.

An open-base transistor, also known as floating base transistor, is a configuration of a BJT where the base terminal is left unconnected or open. In other words, there is no external electrical connection to the base terminal of the transistor. An open-base configuration is not commonly used for amplification or switching purposes. Instead, it may be used to measure a leakage current or other characteristic of the transistor when the base is left unconnected. In this configuration, the transistor doesn't have a current flowing into or out of its base terminal. As a result, the transistor is not in its active amplification mode. The BJT is essentially turned off and doesn't perform any signal amplification or switching function. The collector current will be very close to zero in this state, and the transistor will not conduct. Examples of floating base transistors are provided in US2018/286853 A1, in US2004/104437 A1 and in US2004/085691 A1.

A BJT in a multi-finger arrangement involves multiple parallel transistor structures integrated onto the same semiconductor substrate. Each "finger" is a single transistor unit, and these fingers are connected in parallel to handle higher currents or power levels collectively. This configuration allows for increased current-carrying capacity and improved performance. The multi-finger arrangement may include alternating emitter and collector stripes, where the emitter and collector regions of the transistor are arranged in alternating stripes or segments along the semiconductor substrate. This arrangement may be used in power transistors to ensure efficient current flow and dissipation. The multi-finger arrangement is often employed in power amplifiers and other high-power applications where increased current-carrying capacity and better thermal management are required. The alternating emitter and collector stripes help to evenly distribute the electrical and thermal stress across the transistor's structure, which is essential for maintaining its performance and reliability under high-power conditions.

The BJT in a multi-finger arrangement may be implemented as an open base transistor.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The invention concerns an open base transistor as defined in independent claim 1. Preferred embodiments and applications are defined in the dependent claims.

According to an aspect of the present disclosure, an open base transistor is presented. The open base transistor may include an emitter region of a first doping polarity. The open base transistor may further include a collector region of the first doping polarity. The open base transistor may further include a base region of a second polarity different from the first doping polarity. The open base transistor may further include an additional region of the first doping polarity. The base region may be resistively connected to the additional region via a resistor. The base region may form diode junctions with the emitter region, the collector region and the additional region. The emitter region and the collector region each may be connected to respective external contacts.

In an embodiment, the additional region may be arranged within the base region.

In an embodiment, the additional region may be placed adjacent to the base region and form a diode junction with the base region. At least part of the additional region may not be in contact with the base region.

In an embodiment, the emitter region and the collector region may be arranged at a surface side of the open base transistor.

In an embodiment, the emitter region and the collector region may be arranged at different sides of the open base transistor.

In an embodiment, the open base transistor may further include an additional buried region of the first doping polarity. The additional buried region may form a diode junction with the base region. The additional buried region may be connected to the additional region. The additional buried region may be arranged in a layer below the base region. The additional buried region may be at least partly arranged below at least one of the emitter region and the collector region.

In an embodiment, the bulk region may have the first polarity type. The bulk region may form a diode junction with the base region. The bulk region may be connected to the additional region.

In an embodiment, a doping level of the additional buried region or a bulk region may be at least 10 times greater than a doping level of the base region.

In an embodiment, the open base transistor may further include a base contact region of the second polarity. The base contact region may be arranged in or at the base region. The base contact region may be arranged at the surface side of the open base transistor. The resistor may be connected to the base region via the base contact region.

In an embodiment, the open base transistor may be symmetrical. The emitter region and the collector region may be reversible in operation.

In an embodiment, the emitter region and the collector region may be arranged in multiple stripes.

In an embodiment, the open base transistor may further include an additional diffusion region arranged below and adjacent to the emitter region. A further additional diffusion region may be arranged directly below the collector region. The further additional diffusion region may have a doping level higher than a base doping level.

In an embodiment, the transistor may have a value in a range of 100 Ohm to 100 kOhm.

According to an aspect of the present disclosure, a semiconductor device is presented. The semiconductor device may include an open base transistor having one or more of the above-described features.

According to an aspect of the present disclosure, an electrostatic discharge (ESD) protection device is presented. The ESD protection device may include an open base transistor having one or more of the above-described features. The ESD protection device may further include a resistor arranged between a base region and an additional region of the open base transistor.

### Brief description of the Drawings

Embodiments of the present disclosure will now be described, by way of example only, with reference to the accompanying schematic drawings in which corresponding reference symbol indicate corresponding parts, in which:

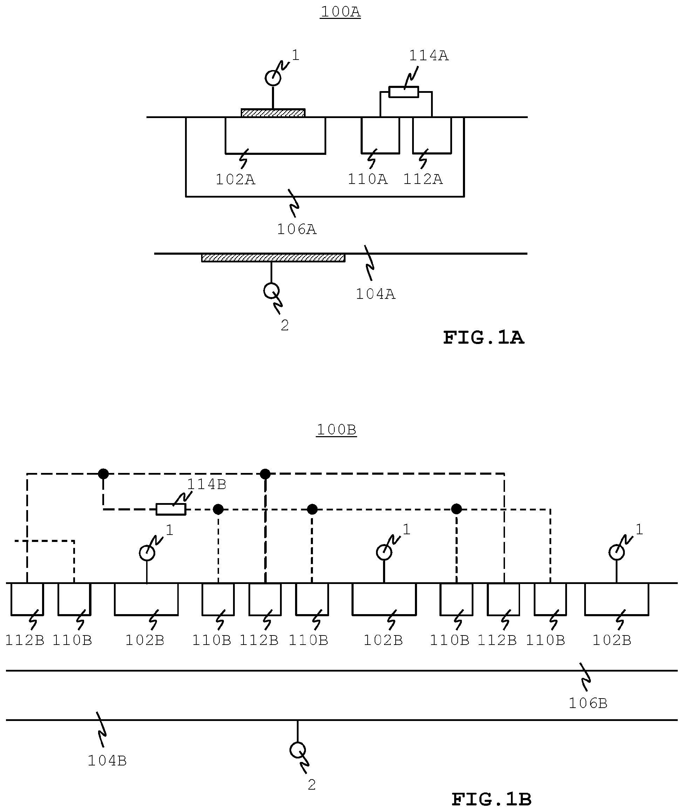

Figs. 1A-7 show example embodiments of open base transistors.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

Open base transistors are frequently used in ESD protection devices. Due to transistor feedback, the clamping voltage is much smaller compared to simple diodes in reverse mode, making open base transistors more suitable in applications such as ESD protection devices. Furthermore, open base transistors offer the possibility to create fully electrically-symmetrical devices.

At least two problems may be encountered with known open base transistor solutions. Firstly, the leakage current of the open base transistor is much higher than the leakage current of a similar transistor with the base connected to the emitter. Secondly, lateral open base transistors concentrate the current at the edge of the collector diffusion; the central parts of the collector contribute less than the outer parts of the collector regions. The latter problem can only partly be circumvented by applying a multi-finger arrangement with alternating emitter and collector stripes.

The present disclosure overcomes these problems by including an additional collector/emitter region in the open base transistor. The additional collector/emitter region may be placed within or next to the floating base. Furthermore, the additional collector/emitter region is connected to the base via a resistor, preferably an external resistor.

The additional collector/emitter region is of same doping polarity as the emitter and collector of the transistor. I.e., in an NPN transistor the additional collector/emitter region is an additional N-region, and in a PNP transistor the additional collector/emitter region is an additional P-region.

The open base transistor of the present disclosure may be asymmetrical or symmetrical. A change in bias polarity may result in emitter and collector exchanging their roles. I.e., in an NPN transistor each set of N-diffusions may act as emitter for one polarity and as collector for the other polarity, and in a PNP transistor each set of P-diffusions may act as emitter for one polarity and as collector for the other polarity. Hence, the additional region introduced by the present disclosure may be referred to as additional collector/emitter region, indicating the two different roles depending on the bias polarity. In case of an open base NPN transistor, the additional collector/emitter region may be referred to as additional N-region. In case of an open base PNP transistor, the additional collector/emitter region may be referred to as additional P-region.

In the following example embodiments of the present disclosure, open base NPN transistors are shown. It will be understood that these example embodiments are similarly applicable to open base PNP transistors by exchanging N-regions and P-regions.

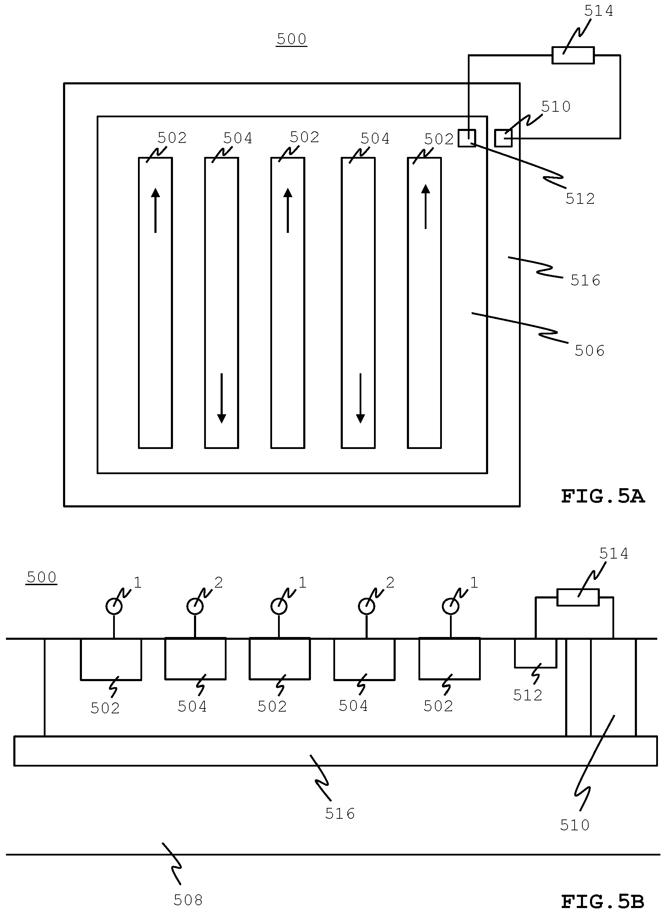

For most embodiments only cross sections are shown and no top views. The length of the structures in the dimension that is not shown might be large, furthermore, the cross sections might show only parts of multi-finger arrangements similar to Fig. 5A.

Fig. 1A shows a first example embodiment of an open base transistor 100A. In Fig. 1A, a cross-sectional side view of the open base transistor 100A is shown. The open base transistor 100A is a vertical and non-symmetrical open base NPN transistor, including an N-emitter region 102A accessible via an emitter contact pad 1, an N-collector region 104A accessible via a collector contact pad 2, and a P-base region 106A.

An additional N-region 110A is arranged in the P-base region 106A, which is resistively connected to the P-base region 106A via a resistor 114A. A P-base contact region 112A may be arranged in the P-base region 106A for connecting the P-base region 106A to the resistor 114A.

In the open base transistor 100A, the additional N-region 110A may be located at the same surface side (i.e., front side) of the crystal as the N-emitter region 102A, with the N-collector region 104A being located at the back of the crystal. The additional N-region 110A may be referred to as additional N-emitter-region 110A.

Fig. 1B shows a variant of the first example embodiment of an open base transistor 100B. In Fig. 1B, a cross-sectional side view of the open base transistor 100B is shown. Similar to the open base transistor 100A, the open base transistor 100B is a vertical and non-symmetrical open base NPN transistor. Where the open base transistor 100A includes one N-emitter region 102A, the open base transistor 100B includes multiple N-emitter regions 102B, each accessible via an emitter contact pad 1. Although three regions are shown in Fig. 1B, multiple regions are possible. Similar to the open base transistor 100A, the open base transistor 100B includes an N-collector region 104B accessible via a collector contact pad 2, and a P-base region 106B.

Additional N-regions 110B are arranged in the P-base region 106B, which may be connected together and which are resistively connected to the P-base region 106B via one or more resistors 114B. P-base contact regions 112B may be arranged in the P-base region 106B for connecting the P-base region 106B to the resistor(s) 114B.

Each of the N-emitter regions 102A is surrounded by an additional N-region 110B. One or more or all of the P-base contact regions 112B may be connected to the same resistor 114B. One or more or all of the additional N-regions 110B may be connected to the same resistor 114B.

Similar to the open base transistor 100A, in the open base transistor 100B, the additional N-regions 110B may be located at the same surface side of the crystal as the N-emitter regions 102B, with the N-collector region 104B being located at the back of the crystal. The additional N-regions 110B may be referred to as additional N-emitter-regions 110B.

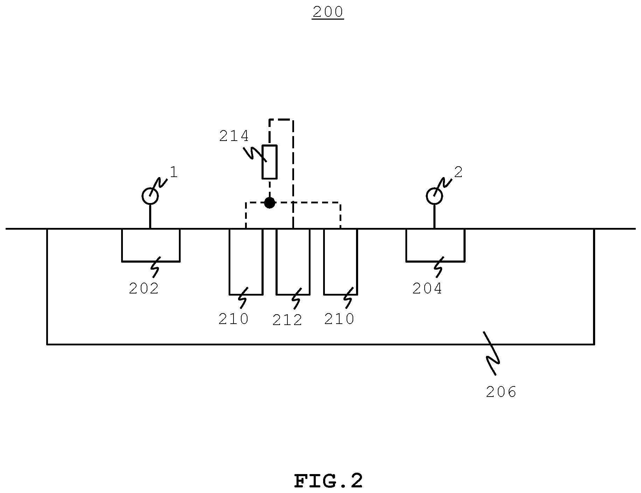

Fig. 2 shows a second example embodiment of an open base transistor 200. In Fig. 2, a cross-sectional side view of the open base transistor 200 is shown. The open base transistor 200 is a lateral symmetrical open base NPN transistor, including an N-emitter region 202 accessible via an emitter contact pad 1, an N-collector region 204 accessible via a collector contact pad 2, and a P-base region 206.

Two additional N-regions 210 surround a P-base contact region 212. The two additional N-regions may be connected (with a short). The P-base region 206 is resistively connected to the additional N-regions 210 via a resistor 214. The P-base contact region 212 may be arranged in the P-base region 206 for connecting the P-base region 206 to the resistor 214. The P-base contact region 214 and the surrounding additional N-regions 210 are arranged between the N-emitter region 202 and the N-collector region 204.

In the open base transistor 200, the N-emitter region 202, the N-collector region 204, the additional N-regions 210 and the P-base contact region 212 may be located at the same surface side of the crystal.

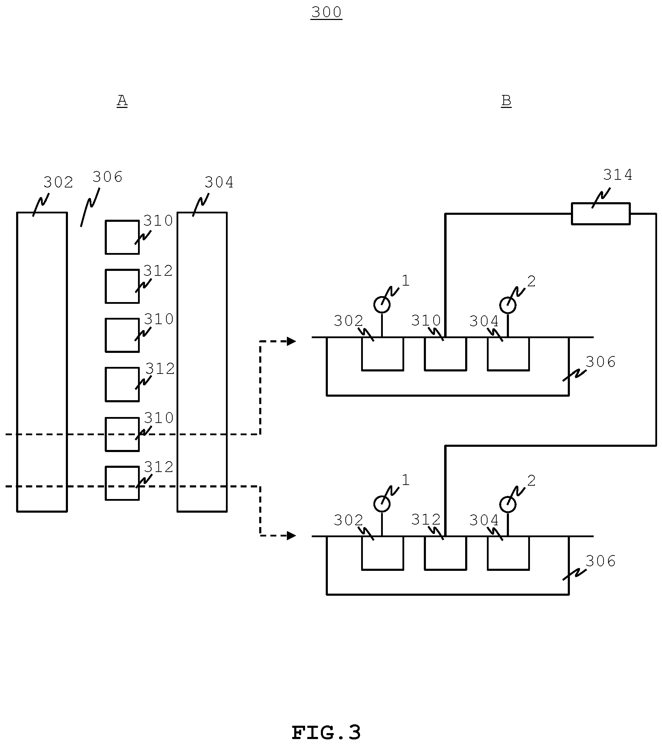

Fig. 3 shows a third example embodiment of an open base transistor 300. In Fig. 3, on the left (indicated "A") a top view and on the right (indicated "B") cross-sectional side views of the open base transistor 300 are shown. The dashed arrows indicate the location of the cross-sections B in the top view A. The open base transistor 300 is a lateral open base NPN transistor, including an N-emitter region 302 accessible via an emitter contact pad 1, an N-collector region 304 accessible via a collector contact pad 2, and a P-base region 306.

Connected additional N-regions 310 are arranged in the P-base region 306, which are resistively connected to the P-base region 306 via one or more resistors 314. P-base contact regions 312 may be arranged in the P-base region 306 for connecting the P-base region 306 to the resistor(s) 314. The additional N-regions and the P-base contact regions 312 are alternatingly arranged in between and parallel to the N-emitter region 302 and the N-collector region 304.

In the open base transistor 300, the N-emitter region 302, the N-collector region 304, the additional N-regions 310 and the P-base contact regions 312 may be located at the same surface side of the crystal.

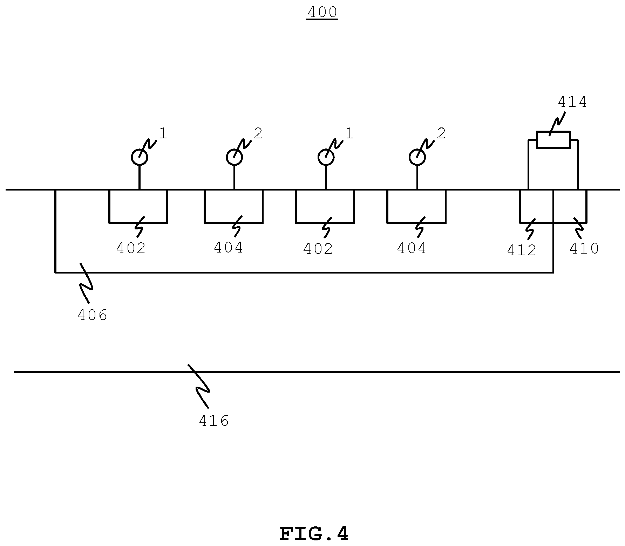

Fig. 4 shows a fourth example embodiment of an open base transistor 400. In Fig. 4, a cross-sectional side view of the open base transistor 400 is shown. The open base transistor 400 is a lateral symmetrical open base NPN transistor, including N-emitter regions 402 accessible via emitter contact pads 1, N-collector regions 404 accessible via collector contact pads 2, and a P-base region 406. The N-emitter regions 402 and the N-collector regions 404 are alternatingly arranged in the P-base region 406.

An additional N-region 410 is arranged outside the P-base region 406, which is resistively connected to the P-base region 406 via a resistor 414. A P-base contact region 412 may be arranged in the P-base region 406 for connecting the P-base region 406 to the resistor 414.

A bulk N-region 416 is arranged below the P-base region 406, such that the N-emitter regions 402 and N-collector regions 404 are arranged on one side of the P-base region 406 and the bulk N-region 416 is arranged on the other side of the P-base region 406. The additional N-region 410 may be arranged in the bulk N-region 416. The additional N-region 410 and the bulk N-region 416 may form one additional N-region. The bulk N-region 416 may be N-doped bulk. The bulk N-region 416 may be highly doped, in which case it may be similar to the additional buried N-region 516 of Fig. 5B.

In the open base transistor 400, the N-emitter regions 402, the N-collector regions 404, the additional N-region 410 and the P-base contact region 412 are located at the same surface side of the crystal.

Fig. 5A and Fig. 5B show a fifth example embodiment of an open base transistor 500. Fig. 5A shows a top view of the open base transistor 500 and Fig. 5B shows a cross-sectional side view of the open base transistor 500. The open base transistor 500 is a lateral symmetrical open base NPN transistor, including N-emitter regions 502 accessible via emitter contact pads 1, N-collector regions 504 accessible via collector contact pads 2, and a P-base region 506 which may also be referred to as P-well 506. The N-emitter regions 502 and the N-collector regions 504 are alternatingly arranged in the P-base region 506. Thus, an array of alternating highly doped N-diffusions is placed in a shared P-well, for example as an array of parallel stripes.

An additional N-region 510 is arranged outside the P-base region 506, which is resistively connected to the P-base region 506 via a resistor 514. A P-base contact region 512 may be arranged in the P-base region 506 for connecting the P-base region 506 to the resistor 514.

An additional buried N-region 516 is arranged directly below the P-base region 506, such that the N-emitter regions 502 and N-collector regions 504 are arranged on one side of the P-base region 506 and the additional buried N-region 516 is arranged on the other side of the P-base region 506. The additional buried N-region 516 may be medium to highly doped. The additional N-region 510 may be arranged in the additional buried N-region 516. The additional N-region 510 and the additional buried N-region 516 may form one additional N-region. Below the burrier N-region 516, a bulk or P-doped region may be arranged.

In the open base transistor 500, the N-emitter regions 502, the N-collector regions 504, the additional N-region 510 and the P-base contact region 512 are located at the same surface side of the crystal.

More generally, the N-diffusions 502, 504 may be connected to two external nodes 1, 2, with odd numbered diffusions (e.g., N-emitter regions 502) to the first node (e.g., emitter contact pad 1) and even numbered diffusions (e.g., N-collector regions 504) to the second node (e.g., collector contact pad 2).

The two sets of N-diffusions may form an open base transistor, an NPN-transistor, with a floating base. In the examples of Figs. 3-5, the system is symmetrical, wherein a change in bias polarity of emitter and collector may exchange their roles. Each set of N-diffusions, such as 302/304, 402/404 or 502/504, may act as emitter for one polarity and as collector for the other polarity.

Fig. 4 and Fig. 5 have in common that the additional emitter/collector is placed below the base diffusion. They are different because in Fig. 4 the additional emitter/collector is formed by the bulk of the silicon crystal, whereas in Fig. 5 the additional emitter/collector is introduced during the production process with typical steps like litho and implant.

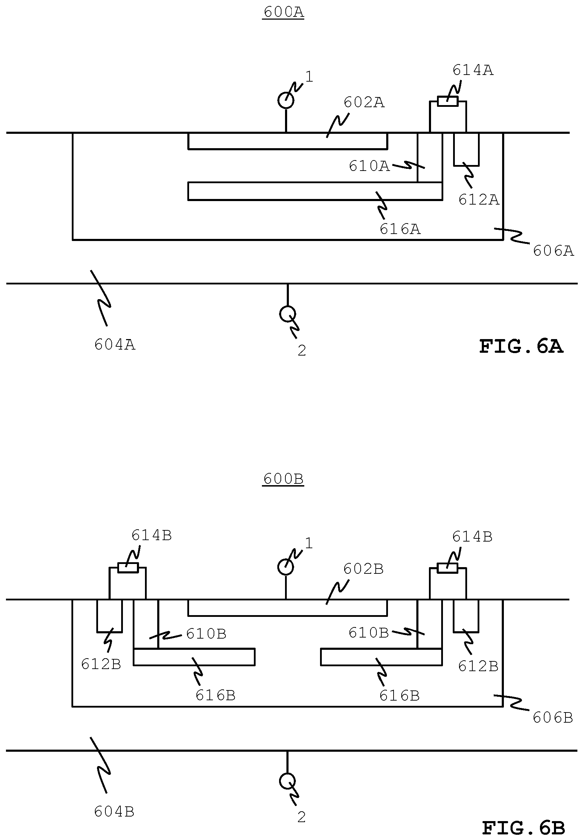

Fig. 6A shows a sixth example embodiment of an open base transistor 600A. In Fig. 6A, a cross-sectional side view of the open base transistor 600A is shown. The open base transistor 600A is a vertical and non-symmetrical open base NPN transistor, including an N-emitter region 602A accessible via an emitter contact pad 1, an N-collector region 604A accessible via a collector contact pad 2, and a P-base region 606A.

An additional N-region 610A is arranged in the P-base region 606A, which is resistively connected to the P-base region 606A via a resistor 614A. A P-base contact region 612A may be arranged in the P-base region 606A for connecting the P-base region 606A to the resistor 614A.

An additional buried N-region 616A is arranged in the P-base region 606A and extends under the N-emitter region 602A. The additional buried N-region 616A connects with the additional N-region 610A.

In the open base transistor 600A, the additional N-region 610A may be located at the same surface side (i.e., front side) of the crystal as the N-emitter region 602A, with the N-collector region 604A being located at the back of the crystal. The additional N-region 610A may be referred to as additional N-emitter-region 610A.

Fig. 6B shows a variant of the sixth example embodiment of an open base transistor 600B. In Fig. 6B, a cross-sectional side view of the open base transistor 600B is shown. Similar to Fig. 6A, the open base transistor 600B is a vertical and non-symmetrical open base NPN transistor, including an N-emitter region 602B accessible via an emitter contact pad 1, an N-collector region 604B accessible via a collector contact pad 2, and a P-base region 606B.

On both sides of the N-emitter region 602B, additional N-regions 610B are arranged in the P-base region 606B, which is resistively connected to the P-base region 606B via a resistor 614B. Next to each additional N-region 610B, a P-base contact region 612B may be arranged in the P-base region 606B for connecting the P-base region 606B to the resistor 614B.

Additional buried N-regions 616B are arranged in the P-base region 606B and extend under the N-emitter region 602B. Each additional buried N-region 616B connects with a respective additional N-region 610B.

Similar to the open base transistor 600A, in the open base transistor 600B, the additional N-regions 610B may be located at the same surface side (i.e., front side) of the crystal as the N-emitter region 602B, with the N-collector region 604B being located at the back of the crystal.

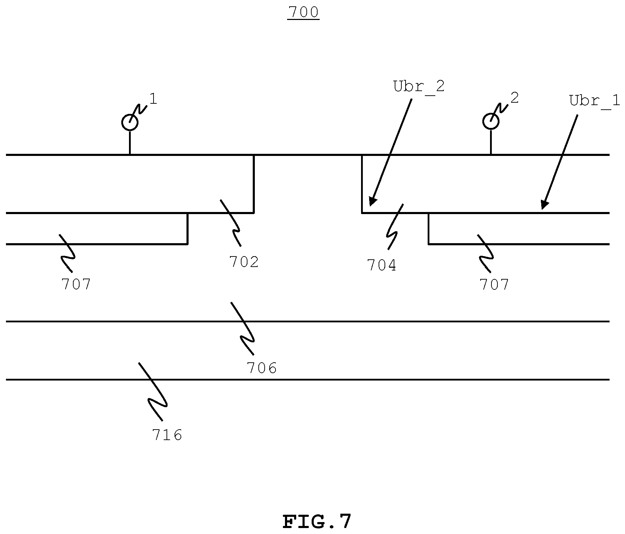

Fig. 7 shows a cross-sectional side view of a part of an example symmetrical open base transistor 700. The open base transistor 700 includes wide emitter/collector fingers (i.e., N-emitter regions 702 and N-collector regions 704) and a P-base region 706. An additional buried N-region 716, which may alternatively be an N-bulk region, is arranged below the P-base region 706.

The open base transistor 700 may be similar to the open base transistor of Figs. 1A-6B. The open base transistor 700 includes one or more additional N-regions, one or more P-base contact regions and a resistor connecting an additional N-region with a P-base contact region (not shown in Fig. 7), such as shown in the examples of Figs. 1A-6B.

Fig. 7 illustrates an optional additional P-diffusion region 707 that may be arranged directly under at least part of each emitter/collector fingers 702/704 for breakdown tuning. The additional P-diffusion region 707 does not extend to the edge of the N-fingers 702, 704 and enables the breakdown voltage Ubr_1 at the bottom of the emitter/collector fingers 702/704 to be tuned, e.g., to be smaller than the breakdown voltage Ubr_2 at the edge of the emitter/collector fingers 702/704.

The open base transistor of the present disclosure, such as shown in any one of the examples of Figs. 1A-7, may advantageously enable leakage current to be reduced. A common disadvantage of known open base transistors is the high leakage level. The inherent leakage current of the blocking base collector junction is amplified by the current gain of the transistor. Therefore, open base transistors show higher leakage currents than similar transistors with a base connection, by a factor of ten to thousand higher. In some embodiments, an additional buried N-region (such as the additional buried N-region 516, 616A, 616B, 716) below the P-base region (also referred to as P-well) (such as P-base region 405, 506, 606A, 606B, 706) may reduce the current gain of the transistor, thus reducing the total leakage current. Additionally or alternatively, an additional N-region (such as the additional N-region 110A, 110B, 210, 310, 410, 510, 610A, 610B) in the P-base region and/or connected to the additional buried N-region may reduce the current gain of the transistor, thus reducing the total leakage current. A large part of the emitted electrons may be "caught" by the additional buried N-region and/or additional N-region and may not reach the collector. The charge added to the additional buried N-region and/or additional N-region by the "caught" electrons may be transported through the additional buried N-region and/or additional N-region and the (preferably external) resistor (such as resistor 414, 514, 614A, 614B) to the P-base region. The voltage drop across this path may be very small: for example, for a (rather large) leakage current of 1 microAmp and a resistor value of 1 kOhm, the voltage drop may only be 1 mVolt. Therefore, the junction between N-region (i.e., N-emitter region or N-collector region) and P-well may never be forward biased and no electrons may be injected from the additional buried N-region and/or additional N-region back into the p-well. Effectively all caught electrons may get lost, similar to the case of electrons that recombine with a hole during their way to the collector. The current gain of the transistor may be reduced and the amplification of the leakage current may be reduced, and as a result the leakage level may be smaller.

The open base transistor of the present disclosure, such as shown in any one of the examples of Figs. 1A-7, may advantageously enable clamping voltage to be reduced and the current capability per area may be increased. If the voltage difference between the two external nodes (such as emitter contact pad 1 and collector contact pad 2) is higher than the breakdown voltage of the N-diffusion to the P-base region (also referred to as P-well) (such as P-base region 405, 506, 606A, 606B, 706), the NPN-transistor may enter into its conducting mode. The base collector junction will go into breakdown and the emitter base junction will be forward biased. When used as an ESD protection (e.g., placed between a signal line and ground) this current path may drain unwanted stress current to ground, thus limiting the voltage on the signal line. One set of N-diffusions (e.g., N-emitter regions 102A, 102B, 202, 302, 402, 502, 602A, 602B, 702) may act as an emitter, injecting electrons into the P-well. The other set of N-diffusions (e.g., N-collector regions 104A, 104B, 204, 304, 404, 504, 604A, 604B, 704) may act as a collector of the transistor. The junction between the collector and the P-well base may be in breakdown mode, the breakdown current delivering the base current for the transistor. Some of the emitted electrons may reach the collector side directly, while some may reach the additional buried N-region and/or the additional N-region. Within the additional buried N-region, the electrons may be transported to a position below the collector and emitted into the p-well base below the collector where they may eventually reach the collector. The additional buried N-region may thus "mirror" or "reflect" the electrons up to the collector.

The additional buried N-region and/or additional N-region may fulfill the same function for both external polarities. With a change in polarity, emitter and collector will change roles. For both polarities the additional buried N-region and/or additional N-region may "reflect" injected electrons up the actual collector.

The connection between the additional buried N-region and/or additional N-region and the P-base region preferably does not hamper the injection of electrons from the additional buried N-region and/or additional N-region into the P-base region. This is due to the value of the connecting resistor, chosen to be preferably in the kOhm range. The current forced through a device using the open base transistor may be much larger than 1 Ampere, especially when used as an ESD protection circuit. The voltage drop across the resistor may be sufficient to strongly forward bias the junction between the additional buried N-layer and/or additional N-region and the P-base region. Only a small part of the current collected by the N-region may be fed through the resistor, the main part may be used in the forward mode of the junction. For example: if 1 mA is flowing through a resistor with 1kOhm, then the voltage drop will be 1 Volt, much larger than the forward voltage of a silicon PN-junction. So, the largest part of the collected current may be injected as electrons by the forward biased junction.

Furthermore, it is advantageous that most of the emitted electrons reach the collector without recombination in the base region. Without the additional buried N-region and/or additional N-region, many of the emitted electrons may diffuse into the bulk of the semiconductor device, where they can recombine with holes. This recombination would reduce the emitter efficiency which would lead to a smaller current gain of the transistor. A smaller current gain results in an unwanted higher clamping voltage.

Another advantage of an additional buried N-region is that it may collect emitted electrons from the whole width of the emitter N-diffusions and transport the mirrored electrons to any place below the collector N-diffusions, especially to the center of the diffusions. Without the additional buried N-region, only a few electrons would reach the center of the collector stripes, and only a few electrons would be emitted from the center of the emitter stripes. This may be more pronounced for wide stripes of N-emitter/N-collector regions, where the width of the stripes is larger than the distance of the stripes. With an additional buried N-region and/or additional N-region, a much larger portion of the emitter and collector stripes may be active than without the additional buried N-region and/or additional N-region.

Multi-finger open base transistors, such as the open base transistor 100B, 400, 500, may be lateral semiconductor devices in the sense that the current flows parallel to the surface of the crystal. In such configurations, the edges of the diffusion stripes contribute most to the total current, the center of the stripes contribute less, due to the larger resistance between the centers than between the edges of the stripes. Therefore, lateral multi-finger transistors are commonly designed with very narrow stripes. Typically, the width of the stripes is similar to the distance of the stripes and the depth of the diffusions. In cases where the available space is a limiting factor for the design of a semiconductor device, the current capability is basically limited by the total width of the transistor, because the edges of the stripes are the main contributors to the current transport. The total width is then limited by the number of stripes that can be placed within the available area. The stripes must have a certain distance, defined by the process capabilities of the diffusion process and by the electrical behavior of the transistor. Thus, the total current capability per area is limited by the width- and distance-rules for the N-diffusions.

In multi-finger open based transistors, if the center parts of the stripes are active, as may be the case when an additional buried N-region is placed below the P-base region, then advantageously wider stripes become feasible and the total current capability per area may be larger than for a known lateral striped transistor where only the edges of the stripes are active. Therefore, an arrangement according to the present disclosure offers a better performance measured in current density per area compared to known arrangements that do not use an "electron mirror".

The resistive connection (in the examples of Figs. 1A-6B through the resistor 114A, 114B, 214, 314, 514, 614A, 614B) between the additional buried N-region (in the examples of Figs. 5-7 the additional buried N-region 516, 616A, 616B, 716) and/or additional N-region (in the examples of Figs. 1A-6B the additional N-region 110A, 110B, 210, 310, 410, 510, 610A, 610B) and the P-base region (in the examples of Figs. 1A-7 the additional N-region 106A, 106B, 206, 306, 406, 506, 606A, 606B, 706) advantageously enables the additional buried N-region and/or additional N-region to act in two different modes for different current levels. For very small currents, the resistive connection may be similar to a short and the additional buried N-region and/or additional N-region may reduce the current gain and consequently the leakage current. For very large currents, the resistive connection may be similar to an open connection and the additional buried N-region and/or additional N-region may improve the electron flow by collecting and re-emitting electrons.

Where in the foregoing reference is made to regions, such as N-emitter region, N-collector region, P-base region, additional P-diffusion region, additional N-region, P-base contact region and additional buried region, these regions may alternatively be referred to as layers, e.g., N-emitter layer, and etcetera.

The resistor, such as resistor 114A, 114B, 214, 314, 514, 614A, 614B, is preferably an internal resistor, i.e., internal on the semiconductor device, preferably apart from the open base transistor region. Alternatively, the resistor may be external to the semiconductor device, i.e., external to the semiconductor device including the open base transistor according to the present disclosure, in which case the resistor may be soldered to contact pads connected to the additional N-region and the P-base contact region.

The P-base region, such as P-base region 106A, 106B, 206, 306, 406, 506, 606A, 606B, 706, and the additional buried N-region and/or additional N-region may be connected via a resistor having a preferred value in the kOhm range, possibly having any value between 100 Ohm and 100 kOhm.

## Claims

1. An open base transistor (100A, 100B, 200, 300, 400, 500, 600A, 600B, 700) comprising:
an emitter region (102A, 102B, 202, 302, 402, 502, 602A, 602B, 702) of a first doping polarity;
a collector region (104A, 104B, 204, 304, 404, 504, 604A, 604B, 704) of the first doping polarity;
a base region (106A, 106B, 206, 306, 406, 506, 606A, 606B, 706) of a second polarity different from the first doping polarity; and
an additional region (110A, 110B, 210, 310, 410, 510, 610A, 610B) of the first doping polarity,
wherein the base region forms diode junctions with the emitter region, the collector region and the additional region,
and wherein the emitter region and the collector region each are connected to respective external contacts; **characterized in that** the base region is resistively connected to the additional region via a resistor (114A, 114B, 214, 314, 414, 514, 614A, 614B).

2. The open base transistor according to claim 1, wherein the additional region is arranged within the base region.

3. The open base transistor according to any one of the preceding claims, wherein the additional region is placed adjacent to the base region and forms a diode junction with the base region, where at least part of the additional region is not in contact with the base region.

4. The open base transistor according to any one of the claims 1-3, wherein the emitter region and the collector region are arranged at a surface side of the open base transistor.

5. The open base transistor according to any one of the claims 1-3, wherein the emitter region and the collector region are arranged at different sides of the open base transistor.

6. The open base transistor according to any one of the preceding claims, further comprising:
an additional buried region (516, 616A, 616B, 716) of the first doping polarity, the additional buried region forming a diode junction with the base region,
wherein the additional buried region is connected to the additional region,
wherein the additional buried region is arranged in a layer below the base region,
and wherein the additional buried region is at least partly arranged below at least one of the emitter region and the collector region.

7. The open base transistor according to any one of the preceding claims,
wherein the bulk region has the first polarity type,
wherein the bulk region forms a diode junction with the base region,
and wherein the bulk region is connected to the additional region.

8. The open base transistor according to claim 6, wherein a doping level of the additional buried region or a bulk region is at least 10 times greater than a doping level of the base region.

9. The open base transistor according to any one of the preceding claims, further comprising:
a base contact region (112A, 112B, 212, 312, 412, 512, 612A, 612B) of the second polarity,
wherein the base contact region is arranged in or at the base region,
wherein the base contact region is arranged at the surface side of the open base transistor,
and wherein the resistor is connected to the base region via the base contact region.

10. The open base transistor according to any one of the preceding claims, wherein the open base transistor is symmetrical, wherein the emitter region and the collector region are reversible in operation.

11. The open base transistor according to claim 10, wherein the emitter region and the collector region are arranged in multiple stripes.

12. The open base transistor according to any one of the preceding claims, further comprising:
an additional diffusion region (707) arranged below and adjacent to the emitter region; and
a further additional diffusion region (707) arranged directly below the collector region,
wherein the further additional diffusion region has a doping level higher than a base doping level.

13. The open base transistor according to any one of the preceding claims, wherein the transistor has a value in a range of 100 Ohm to 100 kOhm.

14. A semiconductor device comprising an open base transistor according to any one of the claims 1-13.

15. An electrostatic discharge, ESD, protection device comprising:
an open base transistor according to any one of the claims 1-13; and
a resistor (114A, 114B, 214, 314, 414, 514, 614A, 614B) arranged between a base region (106A, 106B, 206, 306, 406, 506, 606A, 606B, 706) and an additional region (110A, 110B, 210, 310, 410, 510, 610A, 610B) of the open base transistor.

## Patentansprüche

1. Transistor mit offener Basis (100A, 100B, 200, 300, 400, 500, 600A, 600B, 700), umfassend:
einen Emitterbereich (102A, 102B, 202, 302, 402, 502, 602A, 602B, 702) einer ersten Dotierungspolarität;
einen Kollektorbereich (104A, 104B, 204, 304, 404, 504, 604A, 604B, 704) der ersten Dotierungspolarität;
einen Basisbereich (106A, 106B, 206, 306, 406, 506, 606A, 606B, 706) einer zweiten Polarität, die sich von der ersten Dotierungspolarität unterscheidet; und
einen zusätzlichen Bereich (110A, 110B, 210, 310, 410, 510, 610A, 610B) der ersten Dotierungspolarität,
wobei der Basisbereich Diodenübergänge mit dem Emitterbereich, dem Kollektorbereich und dem zusätzlichen Bereich bildet,
und wobei der Emitterbereich und der Kollektorbereich jeweils mit entsprechenden externen Kontakten verbunden sind; **dadurch gekennzeichnet, dass** der Basisbereich über einen Widerstand (114A, 114B, 214, 314, 414, 514, 614A, 614B) mit dem zusätzlichen Bereich resistiv verbunden ist.

2. Transistor mit offener Basis nach Anspruch 1, wobei der zusätzliche Bereich innerhalb des Basisbereichs angeordnet ist.

3. Transistor mit offener Basis nach einem der vorstehenden Ansprüche, wobei der zusätzliche Bereich angrenzend zum Basisbereich platziert ist und einen Diodenübergang mit dem Basisbereich bildet, wo mindestens ein Teil des zusätzlichen Bereichs nicht mit dem Basisbereich in Kontakt steht.

4. Transistor mit offener Basis nach einem der Ansprüche 1 bis 3, wobei der Emitterbereich und der Kollektorbereich auf einer Oberflächenseite des Transistors mit offener Basis angeordnet sind.

5. Transistor mit offener Basis nach einem der Ansprüche 1 bis 3, wobei der Emitterbereich und der Kollektorbereich auf unterschiedlichen Seiten des Transistors mit offener Basis angeordnet sind.

6. Transistor mit offener Basis nach einem der vorstehenden Ansprüche, ferner umfassend:
einen zusätzlichen vergrabenen Bereich (516, 616A, 616B, 716) der ersten Dotierungspolarität, wobei der zusätzliche vergrabene Bereich einen Diodenübergang mit dem Basisbereich bildet,
wobei der zusätzliche vergrabene Bereich mit dem zusätzlichen Bereich verbunden ist,
wobei der zusätzliche vergrabene Bereich in einer Schicht unterhalb des Basisbereichs angeordnet ist,
und wobei der zusätzliche vergrabene Bereich mindestens teilweise unterhalb mindestens eines des Emitterbereichs und des Kollektorbereichs angeordnet ist.

7. Transistor mit offener Basis nach einem der vorstehenden Ansprüche,
wobei der Volumenbereich den ersten Polaritätstyp aufweist,
wobei der Volumenbereich einen Diodenübergang mit dem Basisbereich bildet,
und wobei der Volumenbereich mit dem zusätzlichen Bereich verbunden ist.

8. Transistor mit offener Basis nach Anspruch 6, wobei ein Dotierungsgrad des zusätzlichen vergrabenen Bereichs oder eines Volumenbereichs mindestens zehnmal größer ist als ein Dotierungsgrad des Basisbereichs.

9. Transistor mit offener Basis nach einem der vorstehenden Ansprüche, ferner umfassend:
einen Basiskontaktbereich (112A, 112B, 212, 312, 412, 512, 612A, 612B) der zweiten Polarität,
wobei der Basiskontaktbereich im oder am Basisbereich angeordnet ist,
wobei der Basiskontaktbereich an der Oberflächenseite des Transistors mit offener Basis angeordnet ist,
und wobei der Widerstand über den Basiskontaktbereich mit dem Basisbereich verbunden ist.

10. Transistor mit offener Basis nach einem der vorstehenden Ansprüche, wobei der Transistor mit offener Basis symmetrisch ist, wobei der Emitterbereich und der Kollektorbereich im Betrieb umkehrbar sind.

11. Transistor mit offener Basis nach Anspruch 10, wobei der Emitterbereich und der Kollektorbereich in mehreren Streifen angeordnet sind.

12. Transistor mit offener Basis nach einem der vorstehenden Ansprüche, ferner umfassend:
einen zusätzlichen Diffusionsbereich (707), der unterhalb und angrenzend zum Emitterbereich angeordnet ist;
und einen weiteren zusätzlichen Diffusionsbereich (707), der direkt unterhalb des Kollektorbereichs angeordnet ist,
wobei der weitere zusätzliche Diffusionsbereich einen höheren Dotierungsgrad als ein Basisdotierungsgrad aufweist.

13. Transistor mit offener Basis nach einem der vorstehenden Ansprüche, wobei der Transistor einen Wert in einem Bereich von 100 Ohm bis 100 kOhm aufweist.

14. Halbleitervorrichtung, umfassend einen Transistor mit offener Basis nach einem der Ansprüche 1 bis 13.

15. Vorrichtung zum Schutz vor elektrostatischer Entladung, ESD, umfassend:
einen Transistor mit offener Basis nach einem der Ansprüche 1 bis 13; und
einen Widerstand (114A, 114B, 214, 314, 414, 514, 614A, 614B), der zwischen einem Basisbereich (106A, 106B, 206, 306, 406, 506, 606A, 606B, 706) und einem zusätzlichen Bereich (110A, 110B, 210, 310, 410, 510, 610A, 610B) des Transistors mit offener Basis angeordnet ist.

## Revendications

1. Transistor à base en l'air (100A, 100B, 200, 300, 400, 500, 600A, 600B, 700) comprenant :
une région émettrice (102A, 102B, 202, 302, 402, 502, 602A, 602B, 702) d'une première polarité de dopant ;
une région collectrice (104A, 104B, 204, 304, 404, 504, 604A, 604B, 704) de la première polarité de dopant ;
une région de base (106A, 106B, 206, 306, 406, 506, 606A, 606B, 706) d'une seconde polarité différente de la première polarité de dopant ; et
une région additionnelle (110A, 110B, 210, 310, 410, 510, 610A, 610B) de la première polarité de dopant,
dans lequel la région de base forme des jonctions de diode avec la région émettrice, la région collectrice et la région additionnelle,
et dans lequel la région émettrice et la région collectrice sont chacune reliée à des contacts externes respectifs ; **caractérisé en ce que** la région de base est reliée de manière résistive à la région additionnelle par l'intermédiaire d'une résistance (114A, 114B, 214, 314, 414, 514, 614A, 614B).

2. Transistor à base en l'air selon la revendication 1, dans lequel la région additionnelle est agencée à l'intérieur de la région de base.

3. Transistor à base en l'air selon l'une quelconque des revendications précédentes, dans lequel la région additionnelle est placée adjacente à la région de base et forme une jonction de diode avec la région de base, au moins une partie de la région additionnelle n'étant pas en contact avec la région de base.

4. Transistor à base en l'air selon l'une quelconque des revendications 1 à 3, dans lequel la région émettrice et la région collectrice sont agencées au niveau d'un côté de surface du transistor à base en l'air.

5. Transistor à base en l'air selon l'une quelconque des revendications 1 à 3, dans lequel la région émettrice et la région collectrice sont agencées au niveau de côtés différents du transistor à base en l'air.

6. Transistor à base en l'air selon l'une quelconque des revendications précédentes, comprenant en outre :
une région enterrée additionnelle (516, 616A, 616B, 716) de la première polarité de dopant, la région enterrée additionnelle formant une jonction de diode avec la région de base,
dans lequel la région enterrée additionnelle est reliée à la région additionnelle,
dans lequel la région enterrée additionnelle est agencée dans une couche sous la région de base,
et dans lequel la région enterrée additionnelle est au moins en partie agencée sous au moins l'une de la région émettrice et la région collectrice.

7. Transistor à base en l'air selon l'une quelconque des revendications précédentes,
dans lequel la région de corps présente le premier type de polarité,
dans lequel la région de corps forme une jonction de diode avec la région de base,
et dans lequel la région de corps est reliée à la région additionnelle.

8. Transistor à base en l'air selon la revendication 6, dans lequel un niveau de dopant de la région enterrée additionnelle ou d'une région de corps est au moins 10 fois supérieur à un niveau de dopant de la région de base.

9. Transistor à base en l'air selon l'une quelconque des revendications précédentes, comprenant en outre :
une région de contact de base (112A, 112B, 212, 312, 412, 512, 612A, 612B) de la seconde polarité,
dans lequel la région de contact de base est agencée dans ou au niveau de la région de base,
dans lequel la région de contact de base est agencée au niveau du côté de surface du transistor à base en l'air,
et dans lequel la résistance est reliée à la région de base par l'intermédiaire de la région de contact de base.

10. Transistor à base en l'air selon l'une quelconque des revendications précédentes, dans lequel le transistor à base en l'air est symétrique, dans lequel la région émettrice et la région collectrice sont réversibles en fonctionnement.

11. Transistor à base en l'air selon la revendication 10, dans lequel la région émettrice et la région collectrice sont agencées en de multiples bandes.

12. Transistor à base en l'air selon l'une quelconque des revendications précédentes, comprenant en outre :
une région de diffusion additionnelle (707) agencée sous et adjacente à la région émettrice ; et
une autre région de diffusion additionnelle (707) agencée directement sous la région collectrice,
dans lequel l'autre région de diffusion additionnelle a un niveau de dopant supérieur à un niveau de dopant de la base.

13. Transistor à base en l'air selon l'une quelconque des revendications précédentes, dans lequel le transistor a une valeur dans une plage de 100 Ohm à 100 kOhm.

14. Dispositif à semi-conducteur comprenant un transistor à base en l'air selon l'une quelconque des revendications 1 à 13.

15. Dispositif de protection contre les décharges électrostatiques, ESD, comprenant :
un transistor à base en l'air selon l'une quelconque des revendications 1 à 13 ; et
une résistance (114A, 114B, 214, 314, 414, 514, 614A, 614B) agencée entre une région de base (106A, 106B, 206, 306, 406, 506, 606A, 606B, 706) et une région additionnelle (110A, 110B, 210, 310, 410, 510, 610A, 610B) du transistor à base en l'air.
